Europäisches Patentamt

European Patent Office

Office européen des brevets

(19)

(11) Publication number: **0 086 778**
**B1**

# (12) EUROPEAN PATENT SPECIFICATION

(45) Date of publication of patent specification: **30.12.86**

(21) Application number: **81902511.5**

(22) Date of filing: **26.08.81**

(86) International application number:
**PCT/US81/01152**

(87) International publication number:
**WO 83/00740 03.03.83 Gazette 83/06**

(51) Int. Cl.⁴: **G 01 N 27/42, H 02 J 7/04,**
**G 01 R 19/00**

## (54) BATTERY VOLTAGE MONITORING AND INDICATING APPARATUS.

(43) Date of publication of application:
**31.08.83 Bulletin 83/35**

(45) Publication of the grant of the patent:
**30.12.86 Bulletin 86/52**

(84) Designated Contracting States:
**DE FR GB**

(56) References cited:
**DE-A-3 001 978**
**US-A-3 895 284**
**US-A-3 971 980**
**US-A-3 997 888**
**US-A-4 080 560**
**US-A-4 096 434**
**US-A-4 180 770**
**US-A-4 193 026**
**US-A-4 217 645**

(73) Proprietor: **CATERPILLAR INDUSTRIAL INC.**
**5960 Heisley Road**
**Mentor Ohio 44060 (US)**

(72) Inventor: **MELOCIK, Grant C.**
**11605 Edgewood Drive**
**Chardon, OH 44024 (US)**
Inventor: **BLIGHT, Steven E.**
**6327 North Upland Terrace**
**Peoria, IL 61615 (US)**

(74) Representative: **Brunner, Michael John et al**
**GILL JENNINGS & EVERY 53-64 Chancery Lane**
**London WC2A 1HN (GB)**

Courier Press, Leamington Spa, England.

## Description

### Technical Field

This invention relates generally to voltage level monitoring and indicating apparatus and, more particularly, to apparatus for monitoring and indicating the discharge level of a battery.

### Background Art

In a variety of systems, and for many reasons, it is important to have information or data concerning the voltage level or charge remaining in an energy storage device. For example, in a vehicle such as an electric lift truck, the voltage level or amount of charge remaining in the battery should be monitored and displayed to avoid potential problems. If the battery is used when it has been overly discharged, damage can occur to the battery as well as to electrical components such as motors and controllers that are supplied with power from the battery.

Electronic monitoring and display systems or apparatus have been developed to produce such information to avoid the problems resulting from an overly discharged battery. In one system, the instantaneous battery voltage is compared to a reference voltage. Whenever the instantaneous battery voltage is less than the reference voltage, an oscillator is turned on, whose pulses are counted by a counter. The counter outputs are fed to a digital-to-analog converter which drives the pointer of a gauge indicating the level of charge remaining in the battery. The output of the converter is also fed back to change the reference voltage. Thus, as the battery discharges, the counter is advanced, causing the converter to move the pointer on the gauge from a fully charged towards a fully discharged position and also to reduce the reference voltage.

One problem with the above monitoring and display systems relates to its application for use in state of the art vehicles. As the state of the art advances, these vehicles will have minicomputers including microprocessors to perform a number of functions. However, this prior monitoring and display system is not designed to be used with minicomputers and is expensive.

Furthermore, this prior monitoring and display system is a dedicated system in that it is designed or calibrated for use with a battery of one rated voltage, e.g., a 24 volt battery. A different design or calibration of the prior monitoring and display system would have to be implemented should it be used with, for example, a 36 volt battery. The requirement for two implementations enhances substantially the cost for producing a monitoring and display system for use with different batteries supplying different voltages.

US—A—4217645 discloses a voltage level monitoring and indicating apparatus comprising an input conditioning circuit having means for receiving a first voltage signal; a voltage-to-frequency converter having an input connected to the conditioning circuit and being constructed to produce a frequency signal at an output with the frequency being proportional to the magnitude of a second voltage signal at the input; and, microprocessor means for controlling a display means in response to the pulse frequency signal to display data representative of the first voltage signal. Such an apparatus is hereinafter referred to as of the kind described. Whilst this apparatus does have a microprocessor means, its input conditioning circuit is not capable of automatically adjusting itself to ensure that the second voltage signal is compatible with the voltage-to-frequency converter irrespective of the magnitude of the first voltage signal being received from either one of two different voltage sources.

In accordance with the present invention, an apparatus of the kind described is characterized by the means being able to receive the first voltage signal from any one of a plurality of different voltage sources and the conditioning circuit including means for scaling the first voltage signal to produce the second voltage signal, the scaling factor being selected by the means on the basis of the magnitude of the first voltage signal. The provision of the scaling means enables the apparatus to monitor, for example, either a 24 volt or a 36 volt source without the operator having to adjust the apparatus or the apparatus having to be provided with input conditioning circuits dedicated to particular voltages of voltage sources.

### Brief Description of the Drawings

Fig. 1 is a block diagram of an embodiment of the present invention.

Fig. 2A, Fig. 2B, Fig. 3 and Fig. 4, show flow charts of software used in the present invention.

### Best Mode for Carrying Out the Invention

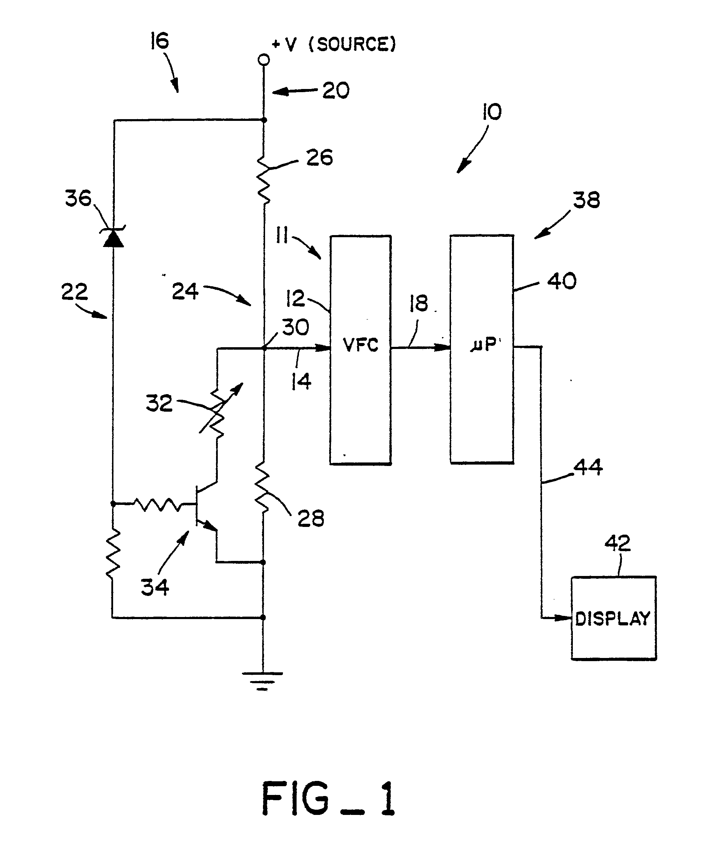

Fig. 1 shows a voltage level monitoring and indicating apparatus 10 that is used to monitor and display data of the voltage level or amount of charge remaining in an energy storage device or source +V. As one example, the source +V being monitored can be a battery (not shown).

A means 11 converts its input signal to an output signal proportional to the input signal. Means 11 is a voltage-to-frequency converter 12 having an input 14 receiving a variable voltage signal as the input signal from an input conditioning circuit 16 whose input itself is a voltage signal from the source +V. Converter 12 produces a pulse train at an output 18 as the output signal having a frequency proportional to the variable voltage signal at input 14. As one example, voltage-to-frequency converter 12 can be model RC4151, manufactured by the Raytheon Corporation of Mountain View, California.

Input conditioning circuit 16 has means 20 for receiving the voltage signal from the source +V. Circuit 16 also has means 22 for shifting this voltage signal to an equivalent voltage signal level at input 14 whether the source +V is any one of a plurality of different sources such as a 24 volt supply or a 36 volt supply. Means 22 has a voltage divider 24 which serves to effect this equivalence. This voltage divider 24 includes a resistor 26 and a resistor 28, in which the output of voltage divider 24 is taken at a junction 30 coupled to the input 14. A series-connected resistor 32 and transistor 34 are connected in parallel across the resistor 28. A zener diode 36 is connected in parallel across resistor 26 and resistor 28 and to the base of transistor 34. Zener diode 36 is constructed to be non-conductive when means 20 is coupled to one of the plurality of voltage sources, for example, source +V of 24 volts, and is conductive when means 20 is coupled to another of the plurality of voltage sources, for example, source +V of 36 volts. Resistor 32 can be variable for reasons to be described below.

If means 20 is connected to the 24 volt source +V so that zener diode 36 does not conduct, the received voltage signal from this source is shifted or divided by resistor 26 and resistor 28 of the voltage divider 24 and supplied to input 14. If means 20 is connected to the 36 volt source +V so that zener diode 36 is conductive, transistor 34 is turned on to operatively couple resistor 32 in parallel with resistor 28. This shifts the received voltage signal from this source to an equivalent level at input 14 that the voltage signal would be if the source +V were the 24 volt source for fully charged 24 volt and 36 volt sources. Thus, converter 12 will produce a pulse train of the same frequency at output 18 whether the input conditioning circuit 16 is connected to one source +V or a different source +V. Variable resistor 32 is an alignment resistor that is preset to produce the same level of voltage signal at input 14 should the source +V be the different source such as the 36 volt supply. Additional zener-transistor-variable resistor circuits could be incorporated to accommodate sources +V of other magnitudes.

A data processor means 38 such as a microprocessor 40 is software programmed to control a display means 42 with voltage level data over a line 44 in response to the frequency of the pulse train being received on output 18. Microprocessor 40 controls display means 42 to display voltage level data indicating the voltage level or remaining charge of source +V. Microprocessor 40 can be, for example, model MK3870 manufactured by the MOSTEK Corporation of Carrollton, Texas and display means 42 can be a conventional LED display.

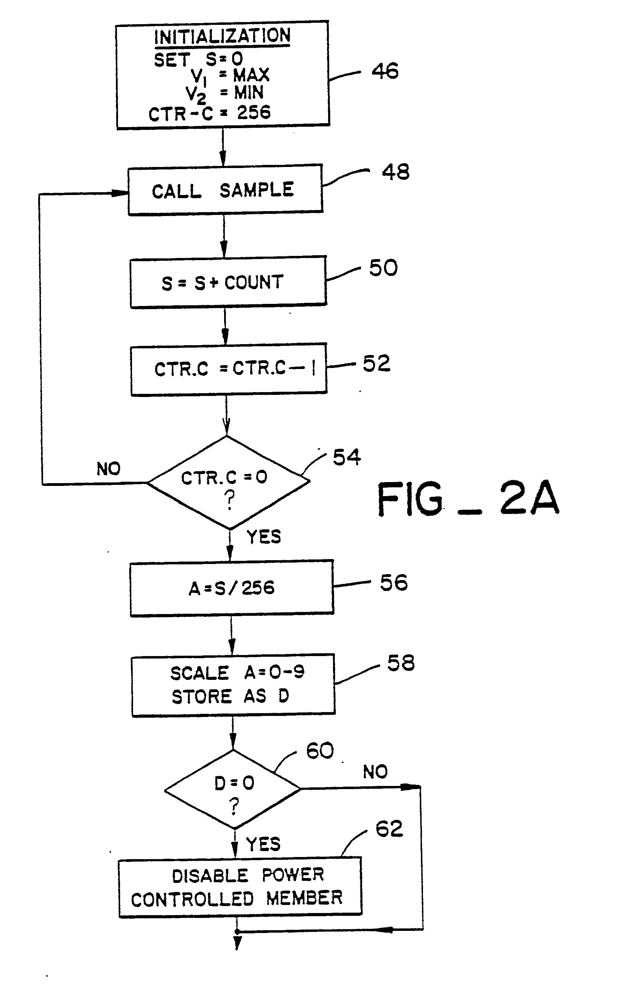

Microprocessor 40 is software programmed in accordance with the flow chart of Fig. 2A, Fig. 2B, Fig. 3 and Fig. 4. At start-up, as part of an initialization procedure (block 46), a storage register S is set equal digitally to O, a storage register $V_1$ is set equal digitally to a predetermined maximum number, and a storage register $V_2$ is set equal digitally to a predetermined minimum number. As will be discussed, display means 42 will display numbers in the range 0—9 in which 9 represents a fully charged source +V and O represents a fully discharged source +V. The initialization procedure also includes setting a counter C equal digitally to 256.

Then, a sample of source voltage data in the form of the pulse frequency signal on line 18 is called by microprocessor 40 (block 48). Microprocessor 40 counts the number of pulses received on line 18 over a period of time. In response to this count, a digital number representing the level of source voltage is produced and added to the digital number stored in register S (block 50). Next, counter C is decremented by 1 (block 52) and, if counter C does not equal O (block 54), a loop is executed in which the program again proceeds through blocks 48, 50, 52, 54.

The loop is executed for 256 counts of counter C which correspond to 256 samples of source voltage data. At the completion of this sampling, register S stores a digital number representing the sum of 256 samples of the source voltage data (block 50) and counter C is equal to O (block 54). Then, microprocessor 40 calculates the average source voltage by dividing the number stored in register S by 256 to produce an average digital number which is stored in a register A (block 56) for this initial start-up period. One purpose for calculating an average over a large number of samplings is to reduce the effect of spurious voltage data or glitches that might occur for any number of reasons.

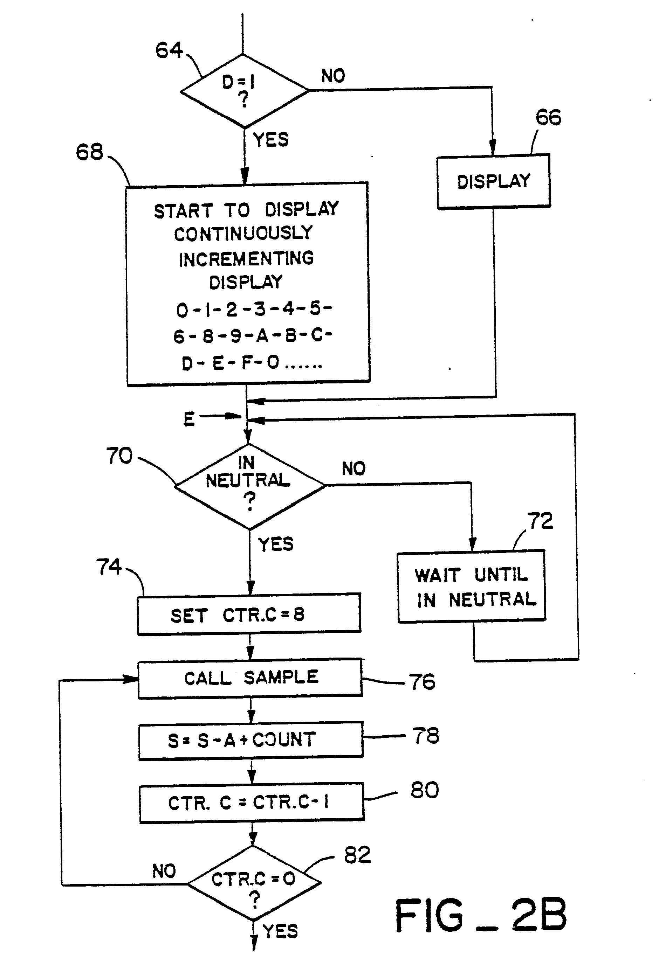

Next, the digital number in register A (block 56) is scaled to a digital number in the range 0—9 and stored in a register D (block 58). If register D equals O (block 60), indicating a fully discharged source +V, a power controlled member, such as a fork lift carriage of a lift truck, is disabled (block 62). This can occur, for example, by opening an electrical contactor (not shown) that couples power from source +V to the controlled member so as possibly not to damage source V or the controlled member. If register D does not equal O (block 60) and does not equal 1 (block 64) (see Fig. 2B), or after disabling the power controlled member (block 62), if register D does not equal 1 (block 64), then the scaled number is displayed (block 66) on display means 42.

If register D is equal to 1 (block 64), indicating a low level of source voltage, then numbers 0—9 and letters A—F are displayed continuously in sequence (block 68). By incrementing continuously the display means 42, a warning will be produced that the source +V is in a low voltage condition and that the controlled member may be disabled shortly.

After this initial start-up in which the average of 256 samples is displayed (block 66) or the sequence is displayed (block 68), a reading of the voltage level of source +V is taken only when the vehicle is in neutral. This is the time when there is constant current draw, and the source +V hasn't dropped due to high current draws. Therefore, if the lift truck is not in neutral (block 70), the program waits until it is in neutral (block 72).

If the lift truck is in neutral (block 70), counter C is set equal to 8 (block 74). Then, a sample of source voltage data is called (block 76), as in block 48, to produce a count or digital number representing the level of source voltage. This count is then added to the summation of the previous 256 samples stored in register S (see block 50), and the previous average stored in register A (see block 56) is subtracted (block 78). Then, counter C is decremented by 1 (block 80) and, if counter C does not equal O (block 82), a loop is executed in which the program proceeds through blocks 76, 78, 80, 82.

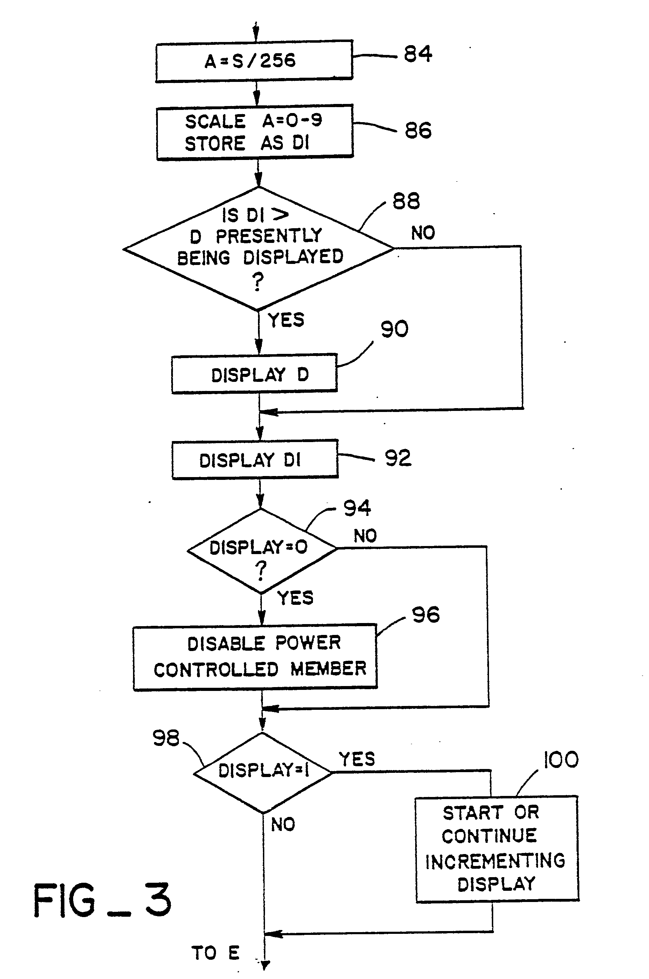

The loop is executed for 8 counts of counter C which correspond to 8 additional samples of source voltage data. The subtractions of the average in register A (block 78) makes room for these 8 samples. At the completion of this sampling, when counter C is equal to O (block 82), a new average is calculated and stored in register A (block 84) (Fig. 3). This allows a slow change in the average so that a bad reading will not be displayed on display means 42. Also, this allows time for source +V to recover if it has just been used extensively.

Next, the new average stored in register A is scaled to a digital number in the range 0—9 and stored in a register D1 (block 86). If the number in register D1 is greater than the number in register D presently being displayed (block 88), then the number in register D continues to be displayed (block 90). If not, then the number in register D1 is displayed (block 92). Thus, display means 42 is monotonic i.e., always decrementing so that it will not display a higher number once a lower number has been displayed, except when sequencing (block 68).

Next, if the display is equal to O (block 94), the power controlled member is disabled (block 96). If not, and the display is equal to 1 (block 98), or after disabling the power controlled member (block 96) if the display is equal to 1 (block 98), then the display starts or continues to be incremented continuously to show the sequence 0—9, A—F (block 100). If the display does not equal 1 (block 98), then the program enters at entry point E (block 70) (Fig. 2B) when the lift truck is next in neutral.

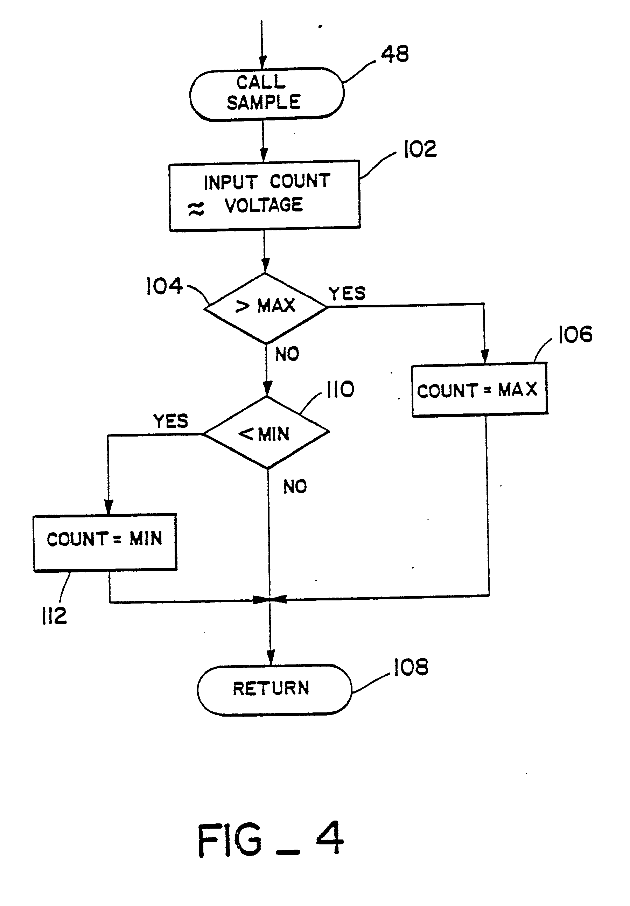

Fig. 4 shows a subroutine when calling a sample (e.g., block 48). A count is obtained in response to the frequency signal on line 18 that is proportional to the voltage level of source +V (block 102). If this count is greater than a maximum initially set in register $V_1$ (block 104), the count is set equal to this maximum (block 106) and a return is made (block 108). If not, and if the count is less than the minimum initially set in register $V_2$ (block 110), the count is set to this minimum (block 112) and the return is made (block 108). If the count is not greater than the maximum (block 104) nor less than the minimum (block 110), the return is made (block 108). These maximum and minimum values represent the maximum and minimum voltages that are expected to be seen in the system at start-up. If the voltages are greater than the maximum or less than the minimum it is assumed that this is a temporary mistake or a fluke. Thus, the count is set either to max (block 106) or min (block 112).

Industrial Applicability

The system 10 can be installed on, for example, an electric fork lift truck to monitor and display data representing the voltage level of a source +V such as a battery. As the lift truck is used and the battery is discharged, the voltage-to-frequency converter 12 will produce at output 18 a pulse frequency signal proportional to the voltage signal at input 14. Microprocessor 40, under software control, periodically will convert the frequency signal to voltage level data on line 44 which represents a range of numbers 0—9 that will be displayed on display means 42.

Should the battery voltage drop to a low level, e.g., register D = 1, then the microprocessor 40 will inform the vehicle operator of this condition by controlling display means 42 to display the sequence of numbers 0—9 and letters A—F. In the event the battery is fully discharged, i.e., register D = O, microprocessor 40 will disable power controlled members such as motors driving a fork lift mast by opening contactors through which battery power is supplied to the motors.

In summary, the present invention is a state-of-the-art microprocessor based system 10 which monitors and indicates changing voltage levels of any source +V, and is inexpensive relative to prior systems. Also, the input conditioning circuit 16 adds flexibility in that the same converter 12 can be coupled to different sources such as a 24 volt battery or a 36 volt battery.

Other aspects, objects and advantages of this invention can be obtained from a study of the drawings, the disclosure and the appended claims.

**Claims**

1. A voltage level monitoring and indicating apparatus (10) comprising an input conditioning circuit (16) having means (20) for receiving a first voltage signal; a voltage-to-frequency converter (12) having an input connected to the conditioning circuit (16) and being constructed to produce a pulse frequency signal at an output (18) with the frequency being proportional to the magnitude of a second voltage signal at the input (14); and, microprocessor means (38) for controlling a display means (42) in response to the pulse frequency signal to display data representive of the first voltage signal; characterized by the means (20) being able to receive the first voltage signal from any one of a plurality of different voltage sources and the conditioning circuit (16) including means (22) for scaling the first voltage signal to produce the second voltage signal, the scaling factor being selected by the means (22) on the basis of the magnitude of the first voltage signal.

2. An apparatus (10) according to claim 1, wherein the scaling means (22) comprises a voltage divider (24) having first and second resistors (26, 28), the input (14) of the converter (12) being connected between the first and second resistors (26, 28); and a third resistor (32) connected in series with a transistor (34), the series connected resistor (32) and transistor (34) being connected in parallel with the second resistor (28).

3. An apparatus (10) according to claim 2, wherein the scaling means (22) comprises a zener diode (36) having a cathode connected to the end of the first resistor (26) remote from the input (14) and an anode connected to a base of the transistor (34).

4. An apparatus (10) according to claim 3, wherein the third resistor (32) is variable.

5. An apparatus (10) according to any of the preceding claims, wherein the microprocessor means (38) is software programmed to take a predetermined number of samples of the pulse frequency signal and to average the predetermined number of samples.

6. An apparatus (10) according to any of the preceding claims, wherein the microprocessor means (38) is software programmed to control the display means (42) to indicate a predetermined voltage level condition.

7. An apparatus (10) according to any of the preceding claims, wherein the microprocessor means (38) is software programmed to control the display means (42) to display any one of a predetermined range of numbers.

8. An apparatus according to claim 7, wherein the microprocessor means (38) is software programmed to control the display means (42) to display a numerical sequence of the numbers in response to a predetermined condition of the first voltage level.

**Revendications**

1. Appareil (10) de contrôle et d'indication d'un niveau de tension, comprenant un circuit adaptateur d'entrée (16) qui comporte des moyens (20) de réception d'un premier signal de tension; un convertisseur tension/fréquence (12) présentant une entrée connectée au circuit adaptateur (16) et conçu pour générer, sur une sortie (18), un signal pulsatoire de fréquence dont la fréquence est proportionnelle à l'amplitude d'un second signal de tension appliqué à l'entrée (14); et un moyen formant microprocesseur (38) pour commander un moyen d'affichage (42) en réponse au signal pulsatoire de fréquence, en vue d'un affichage de données représentatives du premier signal de tension; caractérisé en ce que lesdites moyens (20) sont aptes à recevoir le premier signal de tension de l'une quelconque d'une série de sources de tension différentes et le circuit adaptateur (16) renferme des moyens (22) destinés à calibrer le premier signal de tension pour générer le second signal de tension, le facteur de calibrage étant sélectionné par les moyens (22) en fonction de l'amplitude du premier signal de tension.

2. Appareil (10) selon la revendication 1, dans lequel les moyens de calibrage (22) comprennent un diviseur de tension (24) comportant une première et une deuxième résistances (26, 28) l'entrée (14) du convertisseur (12) étant connectée entre les première et deuxième résistances (26, 28); et une troisième résistance (32) branchée en série avec un transistor (34), la résistance (32) et le transistor (34) branchés en série étant montés en parallèle sur la deuxième résistance (28).

3. Appareil (10) selon la revendication 2, dans lequel les moyens de calibrage (22) comprennent une diode Zener (36) dont une cathode est connectée à l'extrémité, éloignée de l'entrée (14), de la première résistance (26) et dont une anode est reliée à la base du transistor (34).

4. Appareil (10) selon la revendication 3, dans lequel la troisième résistance (32) est variable.

5. Appareil (10) selon l'une quelconque des revendications précédentes, dans lequel le moyen formant microprocesseur (38) est programmé par logiciel de telle façon à pouvoir saisir un nombre prédéterminée d'échantillons du signal pulsatoire de fréquence et à pouvoir faire la moyenne du nombre prédéterminé d'échantillons.

6. Appareil (10) selon l'une quelconque des revendications précédentes, dans lequel le moyen formant microprocesseur (38) est programmé par logiciel de telle façon à pouvoir commander le moyen d'affichage (42) afin qu'il indique un état de niveau de tension prédéterminé.

7. Appareil (10) selon l'une quelconque des revendications précédentes, dans lequel le moyen formant microprocesseur (38) est programmé par logiciel de telle façon à pouvoir commander le moyen d'affichage (42) afin qu'il affiche un nombre quelconque appartenant à une plage prédéterminée de nombres.

8. Appareil selon la revendication 7, dans lequel le moyen formant microprocesseur (38) est programmé par logiciel de telle façon à pouvoir commander le moyen d'affichage (42) afin qu'il affiche une séquence numérique des nombres en réponse à un état prédéterminé du premier niveau de tension.

**Patentansprüche**

1. Spannungspegelüberwachungs- und Anzeigevorrichtung (10), die folgendes aufweist: eine Eingangskonditionierschaltung (16) mit Mitteln (20) zum Empfang eines ersten Spannungssignals, einen Spannungs-zu-Frequenzkonverter (12) mit einem Eingang verbunden mit der Konditionierschaltung (16) und ausgelegt zur Erzeugung eines Impulsfrequenzsignals als eine Ausgangsgröße (18) mit der Frequenz proportional zur Größe eines zweiten Spannungssignals am Eingang (14) und Mikroprozessormittel (38) zur Steuerung von Anzeigemitteln (42) infolge des Impulsfrequenzsignals zur Darstellung von Daten, repräsentativ für das erste Spannungssignal, gekennzeichnet durch Mittel (20) zum Empfang des ersten Spannungssignals von einer aus einer Vielzahl von unterschiedlichen Spannungsquellen und der Konditionierschaltung (16) einschließlich Mitteln (22) zur Maßstabsveränderung des ersten Spannungssignals zur Erzeugung des zweiten Spannungssignals, wobei der Maßstabsfaktor durch die Mittel (22) ausgewählt wird auf der Basis der Größe des ersten Spannungssignals.

2. Vorrichtung (10) nach Anspruch 1, wobei die Maßstabsmittel (22) einen Spannungsteiler (24) mit ersten und zweiten Widerständen (26, 28) aufweisen, wobei Eingang (14) des Konverters (12) zwischen ersten und zweiten Widerständen (26, 28) geschaltet ist und wobei ein dritter Widerstand (32) in Serie mit einem Transistor (34) liegt, wobei der in Serie geschaltete Widerstand (32) und der Transistor (34) parallel mit dem zweiten Widerstand (28) geschaltet sind.

3. Vorrichtung (10) nach Anspruch 2, wobei die Maßstabsmittel (22) eine Zenerdiode (36) aufweisen, und zwar mit einer Kathode, verbunden mit dem Ende des ersten Widerstands (26) entfernt gelegen gegenüber dem Eingang (14) und mit einer mit der Basis des Transistors (34) verbundenen Anode.

4. Vorrichtung (10) nach Anspruch 3, wobei der dritte Widerstand (32) variabel ist.

5. Vorrichtung (10) nach einem der vorhergehenden Ansprüche, wobei die Mikroprozessormittel (38) durch Software programmiert sind, um eine vorbestimmte Anzahl von Tastungen des Impulsfrequenzsignals vorzunehmen und um die vorbestimmte Anzahl von Tastungen zu mitteln.

6. Vorrichtung (10) nach einem der vorhergehenden Ansprüche, wobei die Mikroprozessormittel (38) softwareprogrammiert sind, um die Anzeigemittel (42) zu sterern, und zwar zur Anzeige eines Zustands eines vorbestimmten Spannungspegels.

7. Vorrichtung (10) nach einem der vorhergehenden Ansprüche, wobei die Mikroprozessormittel (38) softwareprogrammiert sind, um die Anzeigemittel (42) zu steuern, und zwar zur Anzeige in einer Zahl aus einem vorbestimmten Zahlenbereich.

8. Vorrichtung nach Anspruch 7, dadurch gekennzeichnet, daß die Mikroprozessormittel (38) softwareprogrammiert sind, um die Anzeigemittel (42) zu steuern, und zwar zur Anzeige einer numerischen Folge von Zahlen infolge eines vorbestimmten Zustands des ersten Spannungspegels.

FIG _ 1

FIG _ 2A

```
          ┌─────────────────────┐
          │   INITIALIZATION    │
          │     SET  S = 0      │
          │      V₁ = MAX       │── 46
          │      V₂ = MIN       │
          │   CTR-C = 256       │
          └─────────────────────┘
                     │
                     ▼
          ┌─────────────────────┐
          │    CALL  SAMPLE     │── 48
          └─────────────────────┘
                     │
                     ▼
          ┌─────────────────────┐
          │    S = S + COUNT    │── 50
          └─────────────────────┘
                     │
                     ▼
          ┌─────────────────────┐
          │   CTR.C = CTR.C — I │── 52
          └─────────────────────┘
                     │
                     ▼
    NO          ◇ CTR.C = 0 ◇ ── 54
   ◄────────────     ?
                     │ YES
                     ▼
          ┌─────────────────────┐
          │      A = S / 256    │── 56
          └─────────────────────┘
                     │
                     ▼
          ┌─────────────────────┐
          │   SCALE  A = 0-9    │── 58
          │    STORE  AS  D     │
          └─────────────────────┘
                     │
                     ▼
              ◇ D = 0 ◇ ── 60    NO
                  ?          ────►
                  │ YES
                  ▼
          ┌─────────────────────┐
          │   DISABLE POWER     │── 62
          │ CONTROLLED MEMBER   │
          └─────────────────────┘
```

FIG _ 2B

64 — D = 1 ? → NO

YES

66 → DISPLAY

68 → START TO DISPLAY CONTINUOUSLY INCREMENTING DISPLAY
0 - 1 - 2 - 3 - 4 - 5 -
6 - 8 - 9 - A - B - C -
D - E - F - 0 ......

E →

70 — IN NEUTRAL ? → NO

YES

72 → WAIT UNTIL IN NEUTRAL

74 → SET CTR.C = 8

CALL SAMPLE — 76

S = S - A + COUNT — 78

CTR. C = CTR.C - 1 — 80

CTR.C = 0 ? — 82

NO

YES

FIG _ 3

FIG _ 4